# EUROPEAN PATENT APPLICATION

(11) **EP 4 464 996 A1**
(43) Date of publication of application: **20.11.2024**
(21) Application number: 23173615.8
(22) Date of filing: 16.05.2023
(51) Int. Cl.: G01F 23/296

(54) **HOUSING ASSEMBLY AND METHOD FOR FORMING THE HOUSING ASSEMBLY**

(71) Applicant: Rosemount Tank Radar AB, 435 23 Mölnlycke (SE)
(72) Inventor: ISAKSSON, Oscar, 431 49 MÖLNDAL (SE); SJÖQVIST, Staffan, 582 31 LINKÖPING (SE); POPA, Cosmin, 424 43 ANGERED (SE); LARSSON, Stig, 433 70 SÄVEDALEN (SE)
(74) Representative: Kransell & Wennborg KB

(57) **Abstract**

A housing assembly (200) for a level sensor field device system (100), the housing assembly comprising: an electrically conductive housing body (202) having an interior hollow portion (204) and an opening (206) in a first end portion (208); an electrically conductive ring (214) comprising protrusions (216) configured to be at least partially deformed when the ring is inserted in the interior hollow portion of the housing body; and a lead (218) electrically connected to the ring, the lead being configured to be connected to circuitry for providing a predetermined electrical potential to the housing body via the ring.

## Description

### Field of the Invention

The present invention relates to a housing assembly for a level sensor field device. In particular, the invention relates to a housing assembly providing a reliable electric connection and to a method for forming the assembly.

### Background of the Invention

Field devices such as vibrating fork level switches are commonly used in industrial applications for point level detection of liquids and solids. These switches are designed to detect the presence or absence of a particular level of a substance in a container or a pipeline.

The switch can be used to detect various types of substances, including liquids, powders, granules, and even sticky substances. They are particularly useful in applications where the substance being measured is subject to changes in temperature, pressure, or viscosity.

Applications of vibrating fork level switches include liquid level measurement and detection in tanks, vessels, and pipelines in industries such as chemical, petrochemical, and pharmaceutical, and solids level detection in hoppers, silos, and bins in industries such as food and beverage, plastics, and mining.

A good ground connection is important in a vibrating fork level switch for accurate and reliable measurement of the substance being measured. The ground connection provides a stable reference point for the electronic circuitry in the switch, which is necessary for the proper functioning of the switch.

However, if the ground connection is poor, the electronic circuitry may not receive a stable reference signal, leading to errors in the measurement. This can result in false alarms or incorrect readings, which can lead to safety hazards or process inefficiencies.

Accordingly, it is desirable to ensure that the field device has a stable and reliable ground connection.

### Summary

In view of above-mentioned problems, it is an object of the present invention to provide a housing assembly for a level sensor field device system and a method for assembling the field device system.

According to a first aspect of the invention, it is therefore provided a housing assembly for a level sensor field device system. The housing assembly comprising: a housing body having an interior hollow portion and an opening in a first end portion; a ring comprising protrusions configured to be at least partially deformed when the ring is inserted in the interior hollow portion of the housing; and a lead electrically connected to the ring, the lead being configured to be connected to circuitry for providing a predetermined electrical potential to the housing body via the ring.

The present invention is based on the realization that a reliable electrical connection, such as a ground connection, can be formed to an electrically conducting housing body of a field device system by providing a housing assembly comprising an electrically conductive ring with protrusions configured to be deformed when the ring is inserted in the housing body. The ring is thereby mechanically fixed in the housing body to ensure that the electrical connection between the ring and housing body is stable over time.

A further advantage of the present invention is that soldering or the like directly to the housing body can be avoided. Soldering or welding inside the housing body can be complicated and by eliminating the need for soldering, the manufacturing process can be simplified. Any required electrical connections can either be formed directly to the ring before the ring is inserted into the housing, or the ring can be equipped with connection elements for facilitating an electrical connection.

According to one embodiment of the invention, the interior hollow portion and the ring have circular cross sections, and wherein an outer diameter of the ring including the protrusions is larger than an inner diameter of the hollow portion of the housing body. The protrusions will thereby be deformed when the ring is inserted in the interior hollow portion to ensure a stable mechanical and electrical connection between the ring and the housing body.

According to one embodiment of the invention the interior hollow portion and the ring have circular cross sections, the interior hollow portion comprising a first section having a first diameter and a second section having a second diameter, the first section being located towards the first end portion of the housing body and the second section being located towards a second end portion of the housing body, wherein an outer diameter of the ring including the protrusions is smaller than an inner diameter of the first section of the hollow portion of the housing body and larger than an inner diameter of the second section of the hollow portion of the housing body.

The change in diameter at the interior hollow portion of the housing body allows the ring to be moved uninterrupted through the first section until it reaches the second section where further unhindered movement is prevented by the protrusions of the ring. This in turn facilitates mounting of the ring in the housing body since the location of the ring in the housing body is at least in part controlled by the change in inner diameter of the hollow portion of the housing body.

According to one embodiment of the invention, the lead connected to the cylindrical ring is a male connector configured to be connected to a corresponding female connector. The lead provides a simple and way of forming an electrical connection to the ring without having to use welding or the like. Moreover, there is no need to form connectors or the like in the housing body as such.

According to one embodiment of the invention, the lead connected to the cylindrical ring is advantageously a spade or pin connector configured to be connected to a corresponding female connector. The electrical connection can thereby be easily formed by attaching the female connection in the axial direction of the housing body.

According to one embodiment of the invention, wherein the protrusions of the ring are provided in the form of a knurled surface. The protrusions may also be provided in the form ridges arranged circumferentially or axially on the outer surface of the ring. The dimensions of the protrusions are adapted so that deformation of the protrusions occur as a result of a suitable amount of force being applied to the ring in the axial direction to press the ring into the interior hollow portion of the housing body.

According to one embodiment of the invention, the ring comprises a groove running circumferentially around the ring, the groove being configured to house a wire. The groove is advantageously formed to have a width which is larger than a diameter of a wire and a depth which is lower than the diameter of the wire so that a wire arranged in the groove can act as an additional crimping element ensuring that the ring is fixed in the housing body when inserted therein.

According to one embodiment of the invention, the ring comprises at least one notch extending inwards from an outer surface of the ring, the notch further comprising a through opening reaching an interior of the ring. The notch and through opening can be used to thread a wire from the inside to the outside of the ring. Moreover, the notch can be used to hold the ring in place during manufacturing steps when attaching a wire or a contact to the ring, for example by welding or soldering.

According to one embodiment of the invention, a portion of the ring configured to face towards the second end portion of the housing body has a tapered profile which may facilitate insertion of the ring into the housing body.

According to one embodiment of the invention, the housing assembly further comprises a level sensor attached to a second end portion of the housing body, opposite the first end portion.

According to a second aspect of the invention, it is provided a method for manufacturing a housing assembly for a level sensor field device system. The method comprises: providing a housing body having an interior hollow portion and an opening in a first end portion; providing a ring comprising protrusions, wherein a diameter of the ring including the protrusions is larger than an inner diameter of the interior hollow portion; and inserting the ring into the interior hollow portion such that the protrusions are at least partially deformed to fix the ring in the interior hollow portion.

Furthermore, inserting the ring may comprises pressing on the ring using a pressing tool. The pressing tool may thus be configured to insert the ring a predetermined distance into the interior hollow portion. The precise placing of the ring can be controlled either by controlling the movement of the pressing tool so that the pressing tool stops at a predetermined position. It is also possible to use protruding elements to stop the axial movement of the ring when it is being pressed in. The pressing tool can then be controlled to provide a predetermined force.

According to one embodiment of the invention, the interior hollow portion comprises a protruding element, and the pressing tool is configured to insert the ring until further movement of the ring is prevented by the protruding element. The protruding element may be a ledge, a ridge or one or more separate protrusion extending from the inner surface towards the interior hollow portion to ensure that the ring is not moved past the position of the protruding element. Such protrusions may facilitate assembly and may also ensure that the ring does not move further down the housing body after assembly.

Effects and features of the second aspect of the invention are largely analogous to those described above in connection with the first aspect of the invention.

Further features of, and advantages with, the present invention will become apparent when studying the appended claims and the following description. The skilled person realize that different features of the present invention may be combined to create embodiments other than those described in the following, without departing from the scope of the present invention.

### Brief Description of the Drawings

These and other aspects of the present invention will now be described in more detail, with reference to the appended drawings showing an example embodiment of the invention, wherein:
Fig. 1 schematically illustrates an exemplary tank arrangement comprising a level sensor field device system;
Fig. 2 is schematic illustration of a housing assembly for a level sensor field device system according to an embodiment of the invention;
Figs. 3A-C schematically illustrate electrically conductive rings for a housing assembly according to embodiments of the invention;
Fig. 4 is a flow chart outlining steps of a method according to an embodiment of the invention;
Fig. 5 schematically illustrates a method of manufacturing a housing according to an embodiment of the invention; and
Fig. 6 schematically illustrates a level sensor field device system and a housing according to an embodiment of the invention.

### Detailed Description of Example Embodiments

In the present detailed description, various embodiments of the housing assembly and method of manufacturing the housing assembly according to the present invention are mainly described with reference to a vibrating fork level sensor installed in a tank located on land. However, the described housing assembly is suitable for use in many other areas.

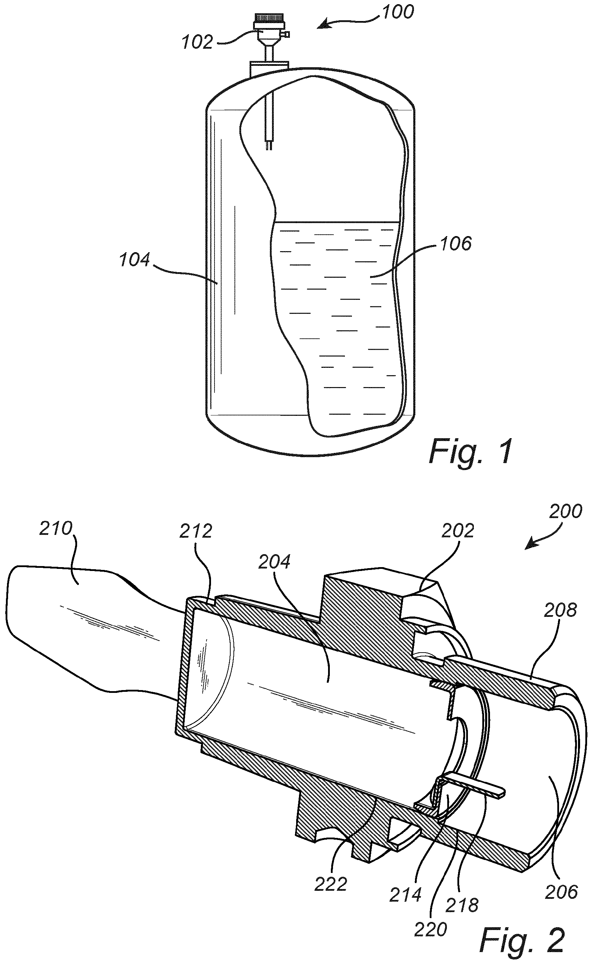

Fig. 1 schematically illustrates a level sensor field device system 100 comprising a measurement unit 102. The level sensor field device system 100 is arranged on top of a tank 104 for detecting a level of a product 106 in the tank 104.

Fig. 2 is a schematic illustration of a housing assembly 200 for the level sensor field device system 100. The housing assembly 200 comprises an electrically conductive housing body 202 having an interior hollow portion 204 and an opening 206 in a first end portion 208. The housing assembly 200 further comprises an electrically conductive ring 214 comprising protrusions 216 configured to be at least partially deformed when the ring 214 is inserted in the interior hollow portion 204 of the housing body 202. The ring 214 is here illustrated as inserted in the housing body 202 and the protrusions 216 have thereby been at least partially deformed to secure and mechanically fix the ring 214 in the housing body 202.

Fig. 2 further illustrates a lead 218 electrically connected to the ring 214, the lead 218 being configured to be connected to circuitry for providing a predetermined electrical potential to the housing body 202 via the ring 214. The lead 218 is here illustrated as a spade connector which can be soldered or spot welded to the ring, but the lead may equally well be a pin connector, or any other type of contact used to easily form an electrical connection to the ring. It is also possible to weld or solder a wire or another type of electrical connection directly to the ring 214 before inserting the ring 214 in the housing body 202.

The housing body 202 is typically configured to in one end be coupled to a vibrating fork level sensor 210 as illustrated in Fig. 2 and in an opposite end be coupled to a measurement unit for controlling the field device. It should however be noted that the described housing assembly can be used in other types of field devices as well. Moreover, even though the housing body 202 is illustrated as consisting of a single part, it may equally well comprise a plurality of parts which when connected together form the housing body 202.

In the illustrated embodiment, the interior hollow portion 204 and the ring 214 both have substantially circular cross sections. It is however in principle sufficient that the ring has an at least partly circular outer diameter such that the ring can be fixed in the substantially cylindrical interior hollow portion 204. Accordingly, it is not required that the ring 214 forms a tight seal against the inner wall of the housing body 202.

Moreover, the interior hollow portion 204 comprises a first section 220 having a first diameter and a second section 222 having a second diameter, the first section 220 being located towards the first end portion 208 of the housing body 202 and the second section 222 being located towards a second end portion 212 of the housing body 202 opposite the first end portion 208. The first end portion 208 can here be seen as the opening 206 where the ring 214 is inserted into the housing body 202 and the second end portion 212 is the part of the housing body 202 to which the level sensor 210 is connected.

An outer diameter of the ring 214 including the protrusions is smaller than an inner diameter of the first section 208 of the hollow portion of the housing body 202 and larger than an inner diameter of the second section 222 of the hollow portion 204 of the housing body 202. The ring can thereby be inserted into the housing body 202 so that is reaches the second section 222 of the housing body 202 without friction in the first section 208, thereby facilitating arrangement of the ring 214 at a selected location in the housing body 202. Accordingly, the solid part of the ring 214 has a smaller diameter than the inner diameter of the second section 222 so that the ring can be inserted without deformation of the overall shape of the ring, meaning that is it preferably only the protrusions of the ring 214 which should be deformed.

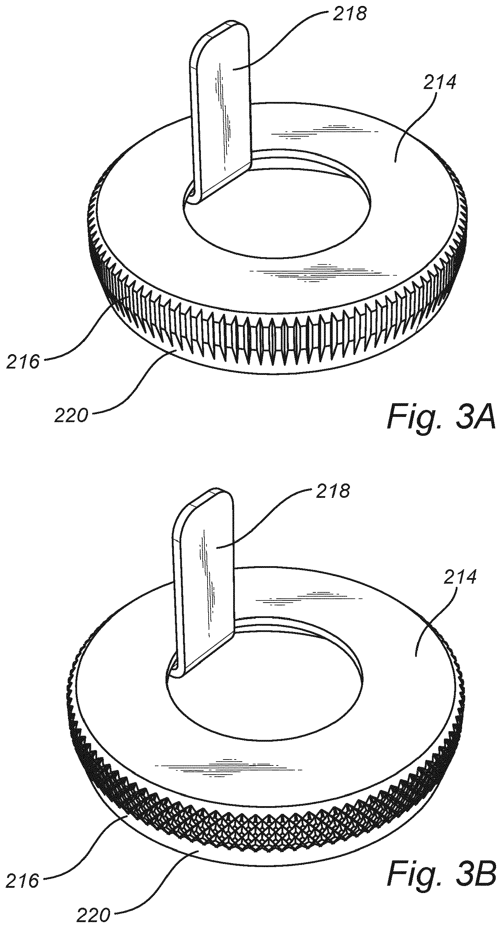

Figs. 3A-C schematically illustrate electrically conductive rings 214 for a housing assembly according to embodiments of the invention. In Fig. 3A the ring comprises protrusions 216 in the form of rides arranged in an axial direction of the ring 214. The ring 214 further comprises a tapered portion 220 facilitating insertion of the ring the housing body 202. The ring 214 illustrated in Fig. 3B comprises a knurled surface consisting of a plurality of protrusions which are configured to be deformed when the ring is inserted into the housing body 202.

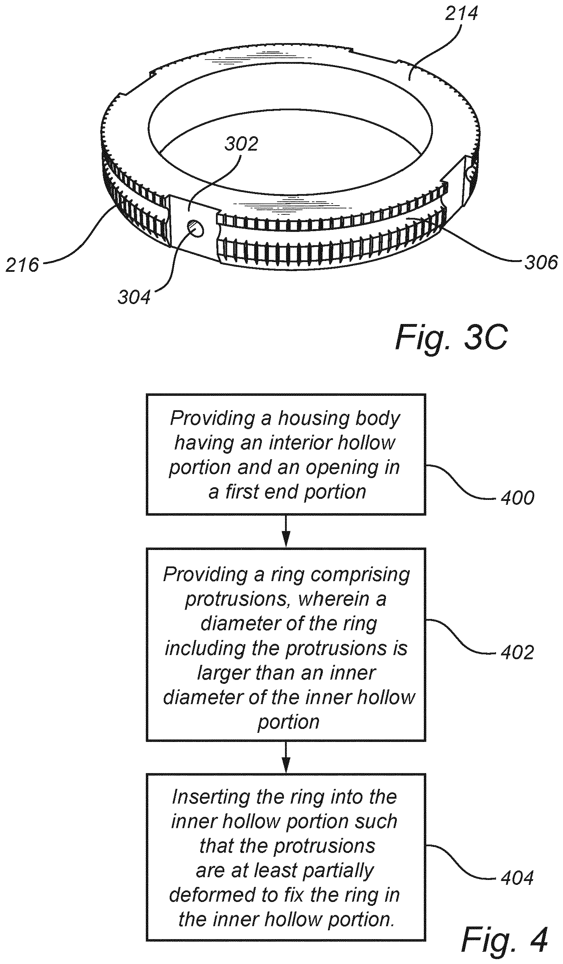

Fig. 3C schematically illustrates a ring 214 comprising at least one notch 302 located at the outer perimeter of the ring 214. Accordingly, the overall outer diameter of the ring 214 still has a circular cross section but with one or more notches 302 extending inwards from the outer surface of the ring 214. The one or more notches 302 can also be used to enable spot welding other welding in applications where it is desirable to weld a cable directly to the ring. The notches may further enable a good supporting surface for the ring during a joining process where the needs to be securely held in place.

The ring 214 of Fig. 3 further comprises a through-opening 304 which is here illustrated at the location of the notch 302 and a groove 306 is running circumferentially around the ring 214. The groove 306 is configured to house a wire or cable (not shown) and the wire can then be threaded through the opening 304 in the notch 302 to reach the inside of the ring 214, thereby facilitating electrical connection of the wire to external circuitry. The groove 306 may advantageously be bit shallower and wider than the diameter of a wire running in the groove 306 in order for the wire to be compressed/squeezed when the ring 214 is pressed into the hollow portion 204. The wire can thereby provide a crimping functionality further ensuring that the ring 214 remains fixed in the housing body 202.

The material of the ring is preferably selected based on both mechanical and electrical properties so that a good electrical connection to the housing body 202 is formed and so that the protrusions can be deformed using an appropriate amount of force when inserting the ring 214. The material of the ring 214 may for example be the same as the material of the housing body 202 to prevent galvanic corrosion.

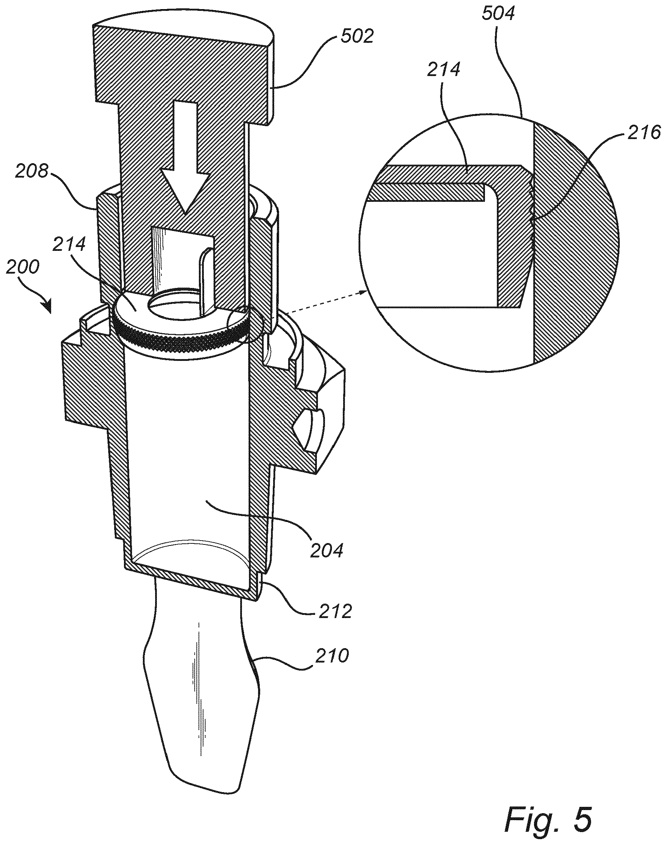

Fig. 4 is a flow chart outlining steps of a method according to an embodiment of the invention which will be described with further reference to Fig. 5 illustrating an arrangement for manufacturing a housing according to an embodiment of the invention.

The method for manufacturing a housing for a level sensor field device system comprises: providing 400 the housing body 202 having an interior hollow portion 204 and an opening 206 in the first end portion; providing 402 the ring 214 comprising protrusions 216, a diameter of the ring including the protrusions 216 being larger than an inner diameter of the interior hollow portion; and inserting 404 the ring 214 into the interior hollow portion 204 such that the protrusions 216 are at least partially deformed to fix the ring 214 in the interior hollow portion.

In the example embodiment illustrated in Fig. 5, the ring 214 is inserted by pressing on the ring 214 using a pressing tool 502 where the final location of the ring 214 may be determined by controlling the stroke length of the pressing tool 502, by controlling the force of the pressing tool, or by providing one or more protruding elements or portions (not shown) in the housing body 202 acting as a stop for the ring 214. The position in the ring 214 in the housing body 202 may for example be controlled by a reduction of the diameter of the interior hollow portion 204 past which the ring 214 cannot be pressed.

The zoomed in portion 504 of Fig. 4 further illustrates deformation of the protrusions 216 when the ring 214 has been inserted into the interior hollow portion 204 of the housing body 202.

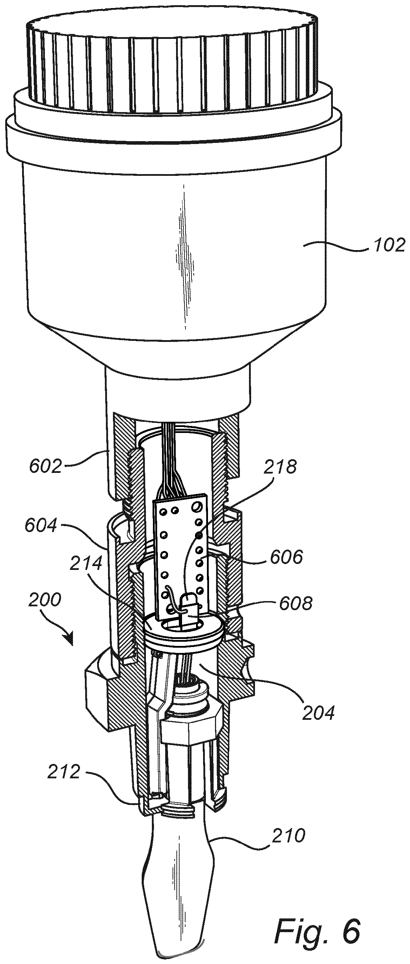

Fig. 6 schematically illustrates a level sensor field device system 100 and a housing assembly 200 according to an embodiment of the invention. The level sensor field device system 100 comprises a measurement unit 102 typically housing measurement circuitry and other functions such as communications circuitry and power supply. The measurement unit 102 in the present example is attached to the housing assembly by a threaded connecting portion 602 via an adapter 604, which may also act as a tank feed-through arrangement.

The fork level sensor 210 is electrically connected to measurement circuitry in the measurement unit 102 through cables running through the central opening of the ring 214. The ring 214 is here electrically connected to circuitry for controlling an electrical potential of the ring, and thereby of the housing body, by a connection board 606 which has a female contact 608 connecting to the male contact 218 of the ring 214. The connection board can in turn be connected to the reliable ground connection can thereby be provided by circuitry in the measurement unit 102. The circuitry providing a ground potential may for example be the measurement circuitry, providing a connection to the same ground potential which is used for the measurement unit 102.

Even though the invention has been described with reference to specific exemplifying embodiments thereof, many different alterations, modifications and the like will become apparent for those skilled in the art. Also, it should be noted that parts of the system and method may be omitted, interchanged or arranged in various ways, the system and method yet being able to perform the functionality of the present invention.

Additionally, variations to the disclosed embodiments can be understood and effected by the skilled person in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage.

## Claims

1. A housing assembly (200) for a level sensor field device system (100), the housing assembly comprising:
an electrically conductive housing body (202) having an interior hollow portion (204) and an opening (206) in a first end portion (208);
an electrically conductive ring (214) comprising protrusions (216) configured to be at least partially deformed when the ring is inserted in the interior hollow portion of the housing body; and
a lead (218) electrically connected to the ring, the lead being configured to be connected to circuitry for providing a predetermined electrical potential to the housing body via the ring.

2. The housing assembly according to claim 1, wherein the interior hollow portion and the ring have circular cross sections, and wherein an outer diameter of the ring including the protrusions is larger than an inner diameter of the interior hollow portion of the housing body.

3. The housing assembly according to claim 1, wherein the interior hollow portion and the ring have circular cross sections, the interior hollow portion comprising a first section (220) having a first diameter and a second section (222) having a second diameter, the first section being located towards the first end portion (208) of the housing body and the second section being located towards a second end portion (212) of the housing body opposite the first end portion, an outer diameter of the ring including the protrusions being smaller than an inner diameter of the first section of the interior hollow portion of the housing body and larger than an inner diameter of the second section of the interior hollow portion of the housing body.

4. The housing assembly according to any one of the preceding claims, wherein the lead connected to the cylindrical ring is a male connector configured to be connected to a corresponding female connector (608).

5. The housing assembly according to any one of the preceding claims, wherein the lead connected to the cylindrical ring is a spade or pin connector configured to be connected to a corresponding female connector.

6. The housing assembly according to any one of the preceding claims, wherein the protrusions of the ring are provided in the form of a knurled surface.

7. The housing assembly according to any one of claims 1 to 5, wherein the protrusions of the ring are ridges.

8. The housing assembly according to any one of the preceding claims, wherein the ring comprises a groove (306) running circumferentially around the ring, the groove being configured to house a wire.

9. The housing assembly according to any one of the preceding claims, wherein the ring comprises at least one notch (302) extending inwards from an outer surface of the ring, the notch further comprising a through opening (304) reaching an interior of the ring.

10. The housing assembly according to any one of the preceding claims, wherein a portion of the ring configured to face towards the second end portion of the housing body has a tapered profile.

11. The housing assembly according to any one of the preceding claims, further comprising a level sensor (210) attached to a second end portion (212) of the housing body, opposite the first end portion.

12. Method for manufacturing a housing for a level sensor field device system, the method comprising:
providing (400) a housing body (202) having an interior hollow portion (204) and an opening (206) in a first end portion;
providing (402) a ring (214) comprising protrusions (216), a diameter of the ring including the protrusions being larger than an inner diameter of the interior hollow portion; and
inserting (404) the ring into the interior hollow portion such that the protrusions are at least partially deformed to fix the ring in the interior hollow portion.

13. The method according to claim 12, wherein inserting the ring comprises pressing on the ring using a pressing tool (502).

14. The method according to claim 13, wherein the pressing tool is configured to insert the ring a predetermined distance into the interior hollow portion.

15. The method according to claim 13, wherein the interior hollow portion comprises a protruding element, the pressing tool being configured to insert the ring until further movement of the ring is prevented by the protruding element.
